# FASCICULE DE BREVET EUROPEEN

(11) **EP 0 733 975 B1**
(45) Date de publication et mention de la délivrance du brevet: **03.06.1998**
(21) Numéro de dépôt: 96470003.3
(22) Date de dépôt: 06.03.1996
(51) Int. Cl.: G06F 11/267, G01R 31/3185

(54) **Interface de sortie de données binaires**
Ausgangschnittstelle für binäre Daten
Binary data output interface

(30) Priorité: 21.03.1995 FR 9503455
(43) Date de publication de la demande: 25.09.1996
(73) Titulaire: SGS-THOMSON MICROELECTRONICS S.A., 94250 Gentilly (FR)
(72) Inventeur: Klingler, Stéphan, 57000 Metz (FR)
(74) Mandataire: Schmit, Christian Norbert Marie

(56) Documents cités:
- EP-A- 0 023 419
- EP-A- 0 414 014
- EP-A- 0 529 945
- US-A- 4 929 889

## Description

L'invention concerne une interface de sortie de données binaires. Elle trouve une application dans la mise au point d'un programme d'instructions exécuté par un circuit de type ASIC, quand on souhaite pouvoir fournir à l'extérieur (on dit aussi tracer) certaines informations internes inaccessibles sur des plots d'accès dédiés.

De nombreux circuits intégrés, tels que les circuits intégrés spécialisés, ou ASIC (de l'anglais Application Specific Integrated Circuit), comprennent une unité centrale, ou processeur, et une mémoire de programme. Cette mémoire est généralement de type mémoire morte (ou ROM). Elle est reliée à l'unité centrale par des bus d'adresse, de donnée et de commande, et contient un programme d'instructions exécutées par l'unité centrale.

Quand un tel circuit intégré a été réalisé sur une puce de silicium, différents tests doivent lui être appliqués. Typiquement, on met en oeuvre deux types distincts de tests. On vérifie d'une part sa constitution physique (caractéristiques des composants, connexions...) par l'envoi de signaux de stimulation. Ce type de test est réalisé en pratique pour tous les circuits réalisés, que ce soit en phase de développement ou en phase de production en série. Le test de la constitution matérielle se fait par exemple par la mise en place, dans les circuits, de registres à décalage permettant d'injecter, via une liaison série, des données dans le circuit et d'échantillonner puis de sortir en série des états logiques présents sur des lignes internes du circuit. On vérifie d'autre part son fonctionnement logique, c'est à dire la manière avec laquelle le circuit exécute le programme contenu dans la mémoire de programme. Ce type de test est réalisé en phase de développement.

Pour le test de déroulement de programme, on cherche entre autre à vérifier que les instructions programmées s'enchaînent de la manière attendue. Une méthode employée consiste à arrêter le programme, par la mise en place de dispositifs de point d'arrêt (ou breakpoint en anglais), quand certaines conditions sont vérifiées. Ce type de test permet de vérifier par exemple quelles valeurs sont positionnées sur des bus d'accès à l'unité centrale suite à l'exécution d'une instruction particulière, puis à reprendre l'exécution du programme. Un inconvénient de ce type de test est que l'on n'a pas une vision fidèle du fonctionnement définitif du circuit puisqu'on perturbe ce fonctionnement en arrêtant le déroulement du programme. On préfère donc souvent procéder également à un test en condition réelle, c'est à dire à l'observation du déroulement, encore dit trace, du programme sans arrêt de celui-ci. Cette observation peut être faîte soit en temps réel soit en temps différé.

Si on souhaite analyser le déroulement temporel réel du programme on procède à une analyse à l'aide d'un analyseur logique. L'analyse en temps réel nécessite que les informations soient directement fournies, lors de l'exécution du programme, sur des ports d'accès du circuit. Cette solution n'est acceptable en pratique que si les dits ports ont une utilité fonctionnelle dans l'utilisation habituelle du circuit et ne sont pas spécifiquement dédiées au test. La taille d'un circuit intégré est directement fonction du nombre de plots d'accès à ce circuit. Or on cherche habituellement à réaliser des circuits qui soient les plus compactes possibles.

Pour mettre en oeuvre l'observation en temps différé, on stocke, dans le circuit ou à l'extérieur de celui-ci, les valeurs successives du compteur d'adresse associé à la mémoire de programme. Puis on analyse à posteriori l'enchaînement de ces valeurs. Une solution consiste à sortir les informations en série. Cela permet de résoudre le problème de l'encombrement mais implique que le débit de sortie des informations est faible.

Un but de l'invention est de pouvoir sortir avec un débit relativement important des informations d'un circuit intégré ayant un nombre réduit de plots d'accès.

Ainsi, l'invention propose un circuit intégré comprenant des plots d'entrée et de sortie pour recevoir de l'extérieur et fournir à l'extérieur des données binaires ou des signaux électriques, ces plots étant reliés à un ou des circuits internes du circuit intégré, et une interface de sortie pour fournir à l'extérieur du circuit intégré des informations binaires, codées sur un nombre entier n de bits, et présentes sur n lignes internes du circuit intégré, caractérisé en ce que l'interface comprend des moyens d'isolation pour isoler du ou des circuits internes auquels ils sont reliés un nombre entier k, avec k inférieur ou égal à n, desdits plots d'entrée et de sortie du circuit intégré et des moyens de connexion pour relier ces k plots aux n lignes internes du circuit intégré de manière que les informations binaires soient fournies à l'extérieur par paquets de k bits.

L'invention propose donc d'utiliser des plots d'accès non dédiés pour sortir les informations, celles ci étant transférées à l'extérieur par paquets de bits.

L'invention sera mieux comprise, et d'autres particularités et avantages apparaîtront dans la description ci-après de modes de réalisation de l'invention, donnés à titre indicatif et nullement limitatif, lue conjointement aux dessins annexés, dans lesquels :

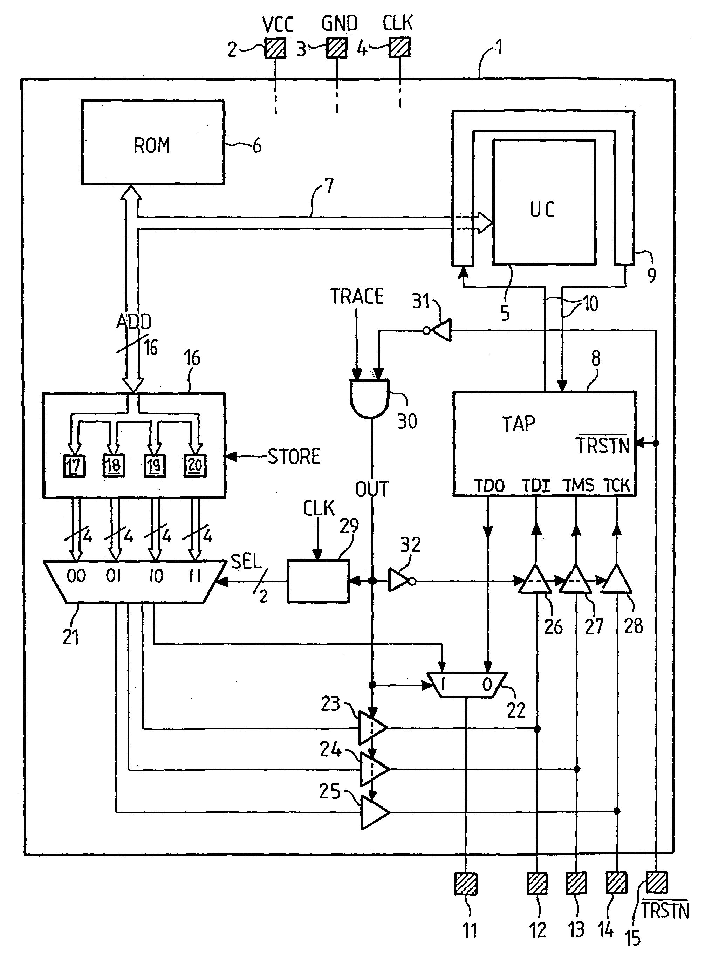

- la figure 1 représente un exemple schématique de circuit comprenant l'invention.

La figure 1 représente un circuit intégré 1 comprenant une interface selon l'invention.

Classiquement, le circuit 1 représenté comprend :
- deux plots 2 et 3 pour recevoir respectivement un potentiel d'alimentation VCC et un potentiel de référence GND,
- une unité centrale 5 et une mémoire de programme 6 reliées par des bus d'adresse (référencé 7), de données (non représenté) et de commande (non représenté).

Dans l'exemple illustré on supposera que l'unité centrale 5 met en oeuvre un programme d'instructions mémorisées dans la mémoire de programme 6, le déroulement du programme étant cadencé par un signal d'horloge CLK reçu sur un plot 4 du circuit.

On supposera, à titre d'exemple, que l'on souhaite analyser l'enchaînement sur le bus d'adresse 6 des adresses, notées ADD et codées en binaire sur un nombre entier n de bits, des instructions mémorisées dans la mémoire 6. On considèrera que n = 16.

On supposera enfin que le circuit 1 comprend par ailleurs un circuit interne de test 8 permettant d'injecter ou d'échantillonner des valeurs binaires sur des lignes du circuit 1, par le biais d'un registre à décalage 9 relié au circuit de test 8 par des lignes 10. Dans l'exemple on considèrera que le circuit de test 8 met en oeuvre la norme IEEE 1149.1 et est accessible depuis l'extérieur du circuit par le biais de cinq plots 11 à 15.

Le circuit de test 8 comprend :
- une entrée de donnée TDI (Test Data Input, reliée au plot 12) pour recevoir des données binaies en série,
- une sortie de donnée TDO (Test Data Output, reliée au plot 11) pour fournir des données binaires en série,
- une entrée de signal de commande TMS (Test Mode Select, reliée au plot 13),
- une entrée de signal d'horloge de test TCK (Test Clock, reliée au plot 14) ,
- une entrée de signal d'initialiation pour recevoir un signal d'initialisation /TRSTN (Test Reset Low) reliée au plot 15.

Pour plus de précision sur ce type de circuit connu de l'homme du métier on se reportera par exemple au document suivant : "The boundary scan handbook", de Kenneth P. Parker, Kluwer Academic Publishers, année 1992.

Pour la compréhension de l'exemple illustré, on prendra en compte les faits suivants :
- le plot 11 est dirigé en sortie, c'est à dire qu'il est utilisé par le circuit interne 8 pour fournir des données à l'extérieur du circuit intégré 1,
- les plots 12 à 15 sont dirigés en entrée, c'est à dire qu'ils sont utilisés pour fournir au circuit interne 8 des données ou signaux de commande depuis l'extérieur du circuit 1,
- le signal logique /TRSTN est représentatif de l'utilisation (/TRSTN = 1) ou non (/TRSTN = 0) du circuit interne 8 (habituellement, après les tests de constitution physique, le circuit interne 8 n'est pas utilisé et le plot 15 est maintenu au potentiel de masse).

L'invention propose d'utiliser les plots 11 à 14 en plots de sortie pour fournir à l'extérieur du circuit 1, par paquet de k = 4 bits, les adresses présentes sur le bus d'adresses 7.

On combine donc les ressources d'émulation et de test physique. Cela est d'autant plus intéressant que ce type de circuit interne de test est habituellement présent dans les circuits intégrés et ceci indépendamment de l'application spécifique du circuit. Ainsi, dans le cadre de développement d'ASICs, le fabriquant propose généralement un coeur de circuit, comprenant une unité centrale et des ressources de test physique par registre à décalage, toujours présents et un certains nombre de dispositifs optionnels choisis par l'utilisateur en fonction de son application. Ceci implique que l'on ne connait pas à priori à quoi serviront les plots d'accès du circuit si ce n'est bien sûr par exemple les plots d'alimentation, et surtout les plots utilisés pour le test de constitution du circuit. Par ailleurs, une fois les test de constitution effectués, les circuits internes de test physique ne sont plus utilisés, et leurs plots d'accès non plus. L'invention propose avantageusement de combiner le transfert par paquet avec une ressource toujours présente sur le circuit, et en pratique inutilisée . En faisant double usage de plots réservés à un usage donné on peut toujours réduire le coût en nombre de plots tout en sortant des informations à un rythme acceptable.

On va maintenant décrire l'interface de sortie des adresses ADD.

L'interface comprend des moyens de stockage des informations (adresses ADD) à sortir. Ces moyens de stockage sont nécessaires dans la mesure où le nombre de plots utilisés est inférieur au nombre de bits de codage des informations. En pratique, si on utilise des plots d'accès à un circuit de test par registre à décalage, il en sera toujours ainsi puisque l'accès à de tels circuits est majoritairement réalisé par liaison série.

Dans l'exemple, les moyens de stockage comprennent un registre 16 formé de quatre sous-registres de quatre bits 17, 18, 19 et 20. Le registre 16 a une entrée parallèle reliée au bus d'adresse 7, formé de seize fils. Pour une adresse ADD, codée sur seize bits, présente sur le bus 7, on stockera cette adresse sous la forme de quatre paquets de quatre bits, chacun des sous-registres 17 à 20 permettant de stoker un des paquets. Chacun des sous registres 17 à 20 a une sortie parallèle, permettant de délivrer son contenu. Chaque sortie de sous-registre comprend donc quatre fils.

Les sorties des sous-registres 17 à 20 sont reliées à un multiplexeur 21 à quatre entrées parallèles et une sortie parallèle, de telle manière qu'en sortie du multiplexeur 21 on retrouve successivement les contenus des quatre sous-registres 17 à 20. En sortie du multiplexeur 21 on dispose donc de quatre bits correspondants à un paquet d'une adresse ADD. La sortie parallèle est formée de quatre sorties, chacune de ces sorties fournissant un bit de chaque paquet de bits. La sélection de l'entrée reliée à la sortie se fait par le biais de signaux de commande SEL reçus d'un compteur 29.

L'interface comprend par ailleurs des moyens de connexion de la sortie du multiplexeur 21 aux plots 11 à 14. Ces moyens de connexion comprennent un multiplexeur 22, et trois circuit tampon trois états référencés 23, 24 et 25.

Le multiplexeur 22 a une entrée reliée à une sortie du multiplexeur 21. Il a une autre entrée reliée à la sortie TDO du circuit de test 8. Il a une sortie reliée au plot 11. Ainsi il permet de relier sélectivement le plot 11 à la sortie TDO ou à une des sorties du multiplexeur 21.

Les trois circuits tampon trois états 23, 24 et 25 comprennent chacun une entrée et une sortie reliées respectivement à l'une des trois autres sorties du multiplexeur 21 et aux plots 12, 13 et 14. Ainsi on peut fournir en parallèle sur les plots 11 à 14 les données présentes en sortie du multiplexeur 21.

L'interface comprend des moyens d'isolation pour isoler les plots 11 à 14 des entrées TDI, TMS, et TCK, et de la sortie TDO du circuit de test 8. Ces moyens d'isolation comprennent d'une part le multiplexeur 22 (qui permet d'isoler la sortie TDO du plot 11) et trois circuits tampon trois états 26, 27, et 28 permettant d'isoler respectivement les plots 12, 13 et 14 des entrées TDI, TMS et TCK.

Enfin l'interface comprend des moyens de commande. Ces moyens de commande comprennent, dans l'exemple illustré, un compteur 29. Avantageusement, on choisira un compteur 2 bits cadencé par le signal d'horloge CLK qui change d'état à chaque front du signal d'horloge CLK. Ce compteur 29 compte de 00 à 11 (en binaire) en deux périodes de signal d'horloge CLK quand il reçoit un signal logique de commande OUT dans un état donné (l'état haut dans l'exemple illustré). Ainsi, on pourra relier successivement les sorties du multiplexeur 21 aux quatre entrées, en un temps égal à deux périodes du signal d'horloge CLK.

Ce signal OUT est produit par une porte ET 30 qui a une entrée reliée au plot 15 par le biais d'un inverseur 31 (et reçoit donc le signal TRSTN) et une entrée recevant un signal logique de commande TRACE. Ainsi si TRACE et TRSTN sont à l'état haut le signal OUT est à l'état haut. Le signal OUT est fourni au multiplexeur 22 et aux circuits tampon 23, 24, et 25. On fournit le signal complémentaire /OUT (produit par le biais d'un inverseur 32) aux circuits tampons 26, 27 et 28. On suppose ici que les circuits tampon 23, 24, et 25 sont transparents (entrée reliée à la sortie) pour OUT = 1, et que les circuits tampon 26, 27, et 28 sont transparents pour OUT = 0.

Le signal de commande TRACE sera fourni de l'extérieur du circuit 1 ou de manière interne (par l'unité centrale 5 par exemple) pour indiquer que l'on souhaite sortir des informations du circuit 1 par le biais des plots 11 à 14. On remarquera que l'on pourrait remplacer le signal OUT par le signal TRSTN, ce qui aboutirait à relier automatiquement les plots 11 à 14 au multiplexeur en l'abscence d'utilisation du circuit interne 8. Cela aboutirait à ne plus respecter la norme IEEE 1149.1 qui définit le rôle d'entrée ou de sortie des plots 11 à 14. Cela pourrait avoir des conséquences lors de la mise en oeuvre de tests de constitution physique parallèlement effectués sur plusieurs circuits reliés via ces plots. D'autre part le signal d'horloge TCK peut ne pas être arrêté quand /TRSTN = 0.

L'avantage d'utiliser un signal de commande TRACE est que la présence de l'interface de sortie sera transparente pour tout utilisateur se contentant d'utiliser les plots 11 à 14 pour l'utilisation seule du circuit 8. Le signal de commande TRACE sera mis par défaut au niveau logique bas, impliquant un respect de la norme IEEE 1149.1 par le circuit 1.

Avantageusement, on utilisera des circuits tampon trois états 26, 27 et 28 avec rappel de la sortie à un potentiel fixe quand l'entrée est isolée de la sortie. Autrement dit on portera les entrées TDI, TMS et TCK du circuit 8 à des potentiels fixes quand elles seront isolées des plots 12 à 14. D'une part cela permet de s'affranchir d'une consommation accrue due à la présence de noeuds flottants (typiquement les entrées attaquent des grilles de commande de transistors). D'autre part, en fixant TMS au potentiel haut (VCC) on reste dans un état logique d'initialisation de test (Test Logic Reset) 8. correspondant à l'état de non utilisation du circuit 8. Pour ce qui concerne les entrées TDI et TCK on pourra au choix les porter au potentiel haut ou au potentiel bas.

On mettra en oeuvre avantageusement un chargement du registre 16 dit en ping-pong, c'est à dire qu'on ne chargera pas en même temps tous les sous-registres 17 à 20. En effet, si on chargeait tous les sous-registres en même temps, on aboutirait à ce que les états des sorties du multiplexeur 21 seraient modifiés en fonction des valeurs chargées dans le sous-registre relié à ces sorties au moment du chargement (en pratique il s'agira du sous-registre comprenant le dernier paquet à sortir). On peut envisager de n'autoriser le chargement (via un signal logique de commande STORE) dans les sous-registres qu'après un certain délai de connexion entre les sorties du multiplexeur 21 et le sous-registre relié à ces sorties au moment du chargement. Cela impliquerait de modifier les moyens de commande pour maintenir périodiquement le compteur 29 dans un état donné. On ralentirait ainsi le débit de sortie des informations.

Dans l'invention on retardera le chargement au moins du sous-registre contenant le dernier paquet à sortir, ce chargement s'effectuant par exemple lors de la sortie du premier paquet de l'adresse ADD suivante. On pourra aussi par exemple charger les sous-registres 17 et 18 alors que les deux sous-registres 19 et 20 sont reliés aux sorties du multiplexeur 21, et charger les sous-registres 19 et 20 alors que les sous-registres 17 et 18 sont reliés aux sorties du multiplexeur. Pour cela il suffit de retarder l'application aux sous-registres 19 et 20 du signal de commande (référence STORE sur la figure 1) validant le chargement des sous-registres 17 à 20. Pour ce faire, il suffit de faire transiter le signal STORE par une bascule à retard. Ainsi, l'invention prévoit une sortie régulière des paquets et optimisée temporellement.

On remarquera qu'il est prévu dans la norme IEEE 1149.1 la possibilité de n'utiliser que quatre plots, la réinitialisation se commandant en utilisant les plots fournissant TMS et TCK. Cela permet de réduire le nombre de plots d'une unité. L'invention est applicable dans cette configuration mais on ne pourra utiliser que les plots reliés à TDI et TDO pour sortir les bits. On divise ainsi par deux le débit de sortie par rapport à l'exemple illustré sur la figure 1. Ce débit demeure néanmoins le double du débit d'une sortie série.

Bien qu'on ait décrit l'invention en référence à un exemple de réalisation préférée, on comprendra que diverses variantes peuvent être apportées sans sortir du cadre de l'invention. Ainsi, on comprendra bien que les plots 11 à 14 ne seront pas nécessairement reliés à un circuit interne de test et à un bus d'adresses. Cela pourra également être un circuit interne de test suivant une norme différente de IEEE 1149.1. D'autre part on adaptera la taille et le nombre de sous-registres en fonction de n et de k. Le nombre n ne sera pas nécessairement un multiple de k, auquel cas il suffira de compléter les valeurs du dernier sous-registre en cablant ses entrées non utilisées à des potentiels fixes. On pourra aussi avoir k = n, auquel cas on pourra se passer de moyens de stockage des informations.

## Revendications

1. Circuit intégré (1) comprenant :
- des plots d'entrée (12, 13, 14, 15) et de sortie (11) pour recevoir de l'extérieur et fournir à l'extérieur des données binaires ou des signaux électriques, ces plots étant reliés à un ou des circuits internes (8) du circuit intégré (1), et
- une interface de sortie pour fournir à l'extérieur du circuit intégré des informations binaires (ADD), codées sur un nombre entier n de bits, et présentes sur n lignes internes (7) du circuit intégré,
caractérisé en ce que l'interface comprend des moyens d'isolation (22, 26, 27, 28) pour isoler du ou des circuits internes (8) auquels ils sont reliés un nombre entier k, avec k inférieur ou égal à n, desdits plots d'entrée et de sortie (11, 12, 13, 14) du circuit intégré (1) et des moyens de connexion (21, 22, 23, 24, 25) pour relier ces k plots aux n lignes internes (7) du circuit intégré (1) de manière que les informations binaires soient fournies à l'extérieur par paquets de k bits.

2. Circuit selon la revendication 1, caractérisé en ce que les moyens d'isolation (22, 26, 27, 28) comprennent un ou des tampons trois-états (26, 27, 28) pour isoler les plots d'entrée (12, 13, 14) des circuits internes (8) et un ou des multiplexeurs (22) pour isoler les plots de sortie (11) des circuits internes (8).

3. Circuit selon l'une des revendications 1 ou 2, caractérisé en ce que n étant supérieur à k, l'interface de sortie comprend des moyens de stockage (16) pour stocker, par paquets de k bits, les n bits des informations binaires (ADD) à sortir et des moyens de multiplexage (21) pour relier les k plots de sortie (11, 12, 13, 14) aux moyens de stockage pour sortir successivement les paquets de k bits.

4. Circuit selon la revendication 3, caractérisé en ce que les moyens de stockage sont composés de registres (17, 18, 19, 20) de k bits.

5. Circuit selon la revendication 4, caractérisé en ce qu'on retarde le stockage dans au moins un des registres, le contenu de ce registre étant fourni à l'extérieur lors du stockage dans les autres registres.

6. Circuit selon l'une des revendications 3 à 5, caractérisé en ce que les moyens de multiplexage (21) sont commandé par un compteur binaire (29) qui est incrémenté à chaque front d'un signal d'horloge (CLK) cadençant le fonctionnement du circuit intégré (1).

7. Circuit selon l'une des revendications 1 à 6, caractérisée en ce qu'on utilise un circuit interne (8) qui est un circuit interne de test (8) du circuit intégré (1).

8. Circuit selon la revendication 7, caractérisé en ce qu'on utilise k plots reliées audit circuit interne de test (8) selon la norme IEEE 1149.1.

9. Circuit selon la revendication 8, caractérisé en ce que :
le circuit interne de test (8) comprend une entrée de donnée (TDI), une sortie de donnée (TDO), une entrée de signal de commande (TMS), une entrée de signal d'horloge de test (TCK) et une entrée de signal d'initialisation pour recevoir un signal d'initialisation (/TRSTN), reliées à des plots du circuit intégré,
les k plots de sortie d'informations binaires, k étant inférieur ou égal à 4, étant choisis parmi les plots reliés à l'entrée de donnée, la sortie de donnée, l'entrée de signal de commande et l'entrée de signal d'horloge de test, et
les moyens d'isolation et de connexion recevant le signal d'initialisation de test (/TRSTN) de telle manière que les k plots soient reliés soit aux entrées et à la sortie du circuit interne de test (8), soit aux n lignes internes (7), en fonction de l'état de ce signal.

## Patentansprüche

1. Integrierte Schaltung (1), mit:
- Eingangsanschlüssen (12, 13, 14, 15) und Ausgangsanschlüssen (11) für den Empfang von binären Daten oder elektrischen Signalen von außen und zum Liefern von binären Daten oder elektrischen Signalen nach außen, wobei diese Anschlüsse mit einer oder mit mehreren internen Schaltungen (8) der integrierten Schaltung (1) verbunden sind, und
- einer Ausgangsschnittstelle für die Lieferung von binären Informationen (ADD), die mit Bits in einer ganzzahligen Anzahl n codiert sind und auf n internen Leitungen (7) der integrierten Schaltung anliegen, nach außerhalb der integrierten Schaltung,
dadurch gekennzeichnet, daß die Schnittstelle Trennmittel (22, 26, 27, 28), die von der oder von den integrierten Schaltungen (8), mit denen sie verbunden sind, Eingangs- und Ausgangsanschlüsse (11, 12, 13, 14) der integrierten Schaltung (1) in einer ganzzahligen Anzahl k, k kleiner oder gleich n, isolieren, und Verbindungsmittel (21, 22, 23, 24, 25) zum Verbinden dieser k Anschlüsse mit den n internen Leitungen (7) der integrierten Schaltung (1) in der Weise, daß die binären Informationen in Paketen von k Bits nach außen geliefert werden, enthält.

2. Schaltung nach Anspruch 1, dadurch gekennzeichnet, daß die Trennmittel (22, 26, 27, 28) einen oder mehrere Dreizustandspuffer (26, 27, 28) zum Isolieren der Eingangsanschlüsse (12, 13, 14) der internen Schaltung (8) sowie einen oder mehrere Multiplexer (22) zum Isolieren der Ausgangsanschlüsse (11) der internen Schaltungen (8) enthalten.

3. Schaltung nach einem der Ansprüche 1 oder 2, dadurch gekennzeichnet, daß dann, wenn n größer als k ist, die Ausgangsschnittstelle Speichermittel (16) zum Speichern von Paketen von k Bits der n Bits der auszugebenden binären Informationen (ADD) und Multiplexermittel (21) zum Verbinden der k Ausgangsanschlüsse (11, 12, 13, 14) mit den Speichermitteln enthält, um nacheinander die Pakete von k Bits auszugeben.

4. Schaltung nach Anspruch 3, dadurch gekennzeichnet, daß die Speichermittel aus Registern (17, 18, 19, 20) aus k Bits aufgebaut sind.

5. Schaltung nach Anspruch 4, dadurch gekennzeichnet, daß die Speicherung in wenigstens einem der Register verzögert wird, wobei der Inhalt dieses Registers während der Speicherung in den anderen Registern nach außen geliefert wird.

6. Schaltung nach einem der Ansprüche 3 bis 5, dadurch gekennzeichnet, daß die Multiplexermittel (21) durch einen binären Zähler (29) gesteuert werden, der bei jeder Anstiegsflanke eines Taktsignals (CLK), das den Betrieb der integrierten Schaltung (1) taktet, inkrementiert wird.

7. Schaltung nach einem der Ansprüche 1 bis 6, dadurch gekennzeichnet, daß eine interne Schaltung (8) verwendet wird, die eine interne Prüfschaltung (8) der integrierten Schaltung (1) ist.

8. Schaltung nach Anspruch 7, dadurch gekennzeichnet, daß k Anschlüsse verwendet werden, die gemäß der Norm IEEE 1149.1 mit der internen Prüfschaltung (8) verbunden sind.

9. Schaltung nach Anspruch 8, dadurch gekennzeichnet, daß:
die interne Prüfschaltung (8) einen Dateneingang (TDI), einen Datenausgang (TDO), einen Steuersignaleingang (TMS), einen Prüf-Taktsignaleingang (TCK) und einen Initialisierungssignaleingang für den Empfang eines Intitialisierungssignals (/TRSTN), die mit den Anschlüssen der integrierten Schaltung verbunden sind, enthält,
wobei die k Ausgangsanschlüsse für binäre Informationen, k kleiner oder gleich 4, aus den Anschlüssen gewählt sind, die mit dem Dateneingang, dem Datenausgang, dem Steuersignaleingang und dem Prüf-Taktsignaleingang verbunden sind, und
wobei die Trenn- und Verbindungsmittel das PrüfInitialisierungssignal (/TRSTN) empfangen, so daß die k Anschlüsse in Abhängigkeit vom Zustand dieses Signals entweder an die Eingänge und an den Ausgang der internen Prüfschaltung (8) oder an die n internen Leitungen (7) angeschlossen werden.

## Claims

1. An integrated circuit (1) comprising :
- input terminals (12, 13, 14, 15) and an output terminal (11) for receiving from the exterior and providing to the exterior binary data or electrical signals, these terminals being connected to one or more internal circuits (8) of the integrated circuit (1), and
- an output interface for providing the exterior of the integrated circuit with binary information (ADD), coded over a whole number n of bits, and presented on n internal lines (7) of the integrated circuit,
**characterised in that** the interface comprises insulating means (22, 26, 27, 28) to insulate, from the internal circuit or circuits (8) to which they are connected, a whole number k, with k being less than or equal to n, of the said input and output terminals (11, 12, 13, 14) of the integrated circuit (10) and connection means (21, 22, 23, 24, 25) to connect these k terminals to the n internal lines (7) of the integrated circuit (1) so that the binary information is provided to the exterior by packets of k bits.

2. A circuit according to Claim 1,
**characterised in that** the insulating means (22, 26, 27, 28) comprise one or more three-state buffers (26, 27, 28) to insulate the input terminals (12, 13, 14) from the internal circuits (8) and one or more multiplexers (22) to insulate the output terminals (11) from the internal circuits (8).

3. A circuit according to one of Claims 1 or 2,
**characterised in that** n being greater than k, the output interface comprises storage means (16) to store, by packets of k bits, the n bits of the binary information (ADD) to be output and multiplexing means (21) to connect the k output terminals (11, 12, 13, 14) to the storage means to output successively the packets of k bits.

4. A circuit according to Claim 3,
**characterised in that** the storage means are composed of registers (17, 18, 19, 20) of k bits.

5. A circuit according to Claim 4,
**characterised in that** storage is delayed in at least one of the registers, the contents of this register being provided to the exterior during storage in the other registers.

6. A circuit according to one of Claims 3 to 5,
**characterised in that** the multiplexing means (21) are controlled by a binary counter (29) which is incremented at each leading edge of a clock signal (CLK) clocking the operation of the integrated circuit (1).

7. A circuit according to one of Claims 1 to 6,
**characterised in that** an internal circuit (8) is used which is an internal test circuit (8) of the integrated circuit (1).

8. A circuit according to Claim 7,
**characterised in that** k terminals connected to the said internal test circuit (8) according to the standard IEEE 1149.1 are used.

9. A circuit according to Claim 8,
**characterised in that** :
the internal test circuit (8) comprises a data input (TDI), a data output (TDO), a control signal input (TMS), a test clock signal input (TCK) and a resetting signal input for receiving a resetting signal (/TRSTN), which are connected to terminals of the integrated circuit, the k output terminals of binary information, k being less than or equal to 4, being chosen from the terminals connected to the data input, the data output, the control signal input and the test clock signal input, and the insulating and connection means receiving the test resetting signal (/TRSTN) so that the k terminals are connected either to the inputs and to the output of the internal test circuit (8), or to n internal lines (7) as a function of the state of this signal.
